# EUROPEAN PATENT SPECIFICATION

(11) **EP 4 475 176 B1**
(45) Date of publication and mention of the grant of the patent: **29.04.2026**
(21) Application number: 22918652.3
(22) Date of filing: 07.01.2022
(51) Int. Cl.: G06N 10/40, H10N 69/00, B81C 1/00, H10W 90/00, H10W 20/20, H10W 70/63

(54) **QUANTUM COMPUTING DEVICE AND METHOD FOR MANUFACTURING QUANTUM COMPUTING DEVICE**
QUANTENCOMPUTERVORRICHTUNG UND VERFAHREN ZUR HERSTELLUNG EINER QUANTENCOMPUTERVORRICHTUNG
DISPOSITIF INFORMATIQUE QUANTIQUE ET PROCÉDÉ DE FABRICATION DE DISPOSITIF INFORMATIQUE QUANTIQUE

(43) Date of publication of application: 11.12.2024
(73) Proprietor: FUJITSU LIMITED, Kawasaki-shi, Kanagawa 211-8588 (JP)
(72) Inventor: TAKAHASHI, Tsuyoshi, Kawasaki-shi, Kanagawa 211-8588 (JP)
(74) Representative: Hoffmann Eitle
(86) International application number: PCT/JP2022/000384
(87) International publication number: WO 2023/132063

(56) References cited:
- JP-A- 2019 532 505
- JP-A- 2021 072 351
- JP-A- H04 338 683
- JP-A- H11 177 157
- US-A1- 2018 013 052
- US-A1- 2019 207 075
- US-B1- 6 528 875
- US-B1- 9 836 699

## Description

### FIELD

The disclosed technology relates to a quantum operation device and a method of manufacturing the quantum operation device.

### BACKGROUND

The followina technology is known as a technology related to a quantum operation device. For example, a technology is known, for example from US 2019/207075 A1, in which a cap layer is bonded to a substrate at which a qubit element is formed to form a sealed vacuum cavity between the cap layer and the substrate.

Furthermore, a technology is known, for example from US 9836699 B1, in which, in a stacked quantum computing device, a first chip includes superconducting qubits and is bonded to a second chip that contains one or a plurality of wiring layers, as well as qubit control and qubit readout elements, integrated with lossy dielectrics.

### SUMMARY

### TECHNICAL PROBLEM

As a qubit element (qubit) constituting the quantum operation device, one using a transmon is known. The transmon has a configuration in which a superconducting Josephson device and a capacitor are coupled in parallel, and performs a quantum operation using nonlinear energy. The transmon operates with extremely small energy, and is thus easily affected by external noise. A time during which the quantum operation may be sustained in the transmon is referred to as a coherence time. The coherence time is sensitively affected by a state around the transmon. For example, in a case where there is a dielectric such as an oxide film around the transmon, the coherence time is shortened due to a dielectric loss. Therefore, it is common that an insulating film such as a protective film is not formed at a surface of the transmon. The quantum operation device configured by including the qubit element is kept at a very low temperature in a vacuum chamber, but an adsorbate that is adsorbed in the atmosphere and causes decoherence is cooled and remains as it is. Since the coherence time is shortened by the adsorbate adsorbed to a surface of the qubit element, it is needed to always keep a clean state of the surface of the qubit element.

An object of the disclosed technology is to keep a surface of a qubit element clean in a quantum operation device.

### SOLUTION TO PROBLEM

A quantum operation device according to the disclosed technology includes: a first substrate that has a through-hole; a qubit element formed at a first surface of the substrate; a cover that covers a side of the first surface of the first substrate; and a second substrate that is provided on a side of a second surface opposite to the side of the first surface of the first substrate and that closes an open end of the through-hole on the side of the second surface. A sealed space that surrounds the qubit element and communicates with the through-hole is provided between the first surface and the cover.

### ADVANTAGEOUS EFFECTS OF INVENTION

According to the disclosed technology, it is possible to keep a surface of a qubit element clean in a quantum operation device.

### BRIEF DESCRIPTION OF DRAWINGS

FIG. 1 is a plan view illustrating an example of a configuration of a quantum operation device according to an embodiment of the disclosed technology.
FIG. 2 is a diagram illustrating an example of a circuit configuration of a qubit element according to the embodiment of the disclosed technology.
FIG. 3 is a diagram illustrating an example of a coupling configuration between qubit elements according to the embodiment of the disclosed technology.
FIG. 4 is a diagram illustrating an example of a circuit configuration of a resonator according to the embodiment of the disclosed technology.
FIG. 5 is a schematic cross-sectional view illustrating an example of the configuration of the quantum operation device according to the embodiment of the disclosed technology.
FIG. 6 is a plan view illustrating an example of a form of a seal member that forms a joint portion between a cover and a first substrate according to the embodiment of the disclosed technology.
FIG. 7 is a plan view illustrating an example of forms of seal members and conductive pads according to the embodiment of the disclosed technology.
FIG. 8 is a plan view illustrating an example of arrangement of through-vias, the seal members, a control electrode, and a bump in the first substrate according to the embodiment of the disclosed technology.
FIG. 9 is a plan view illustrating an example of arrangement of through-vias, conductive pads, and the bump in a second substrate according to the embodiment of the disclosed technology.
FIG. 10 is a cross-sectional view illustrating an example of a method of manufacturing the quantum operation device according to the embodiment of the disclosed technology.
FIG. 11 is a cross-sectional view illustrating the example of the method of manufacturing the quantum operation device according to the embodiment of the disclosed technology.
FIG. 12 is a cross-sectional view illustrating the example of the method of manufacturing the quantum operation device according to the embodiment of the disclosed technology.
FIG. 13 is a cross-sectional view illustrating the example of the method of manufacturing the quantum operation device according to the embodiment of the disclosed technology.
FIG. 14 is a cross-sectional view illustrating the example of the method of manufacturing the quantum operation device according to the embodiment of the disclosed technology.
FIG. 15 is a cross-sectional view illustrating the example of the method of manufacturing the quantum operation device according to the embodiment of the disclosed technology.
FIG. 16 is a cross-sectional view illustrating the example of the method of manufacturing the quantum operation device according to the embodiment of the disclosed technology.
FIG. 17 is a schematic cross-sectional view illustrating an example of a configuration of a quantum operation device according to an embodiment of the disclosed technology.
FIG. 18 is a plan view illustrating an example of a form of a seal member that forms a joint portion between a cover and a first substrate according to the embodiment of the disclosed technology.
FIG. 19 is a schematic cross-sectional view illustrating an example of a configuration of a quantum operation device according to an embodiment of the disclosed technology.
FIG. 20 is a plan view illustrating an example of a form of a seal member that forms a joint portion between a cover and a first substrate according to the embodiment of the disclosed technology.
FIG. 21 is a plan view illustrating an example of a pattern of a capacitor provided in a path of inter-bit wiring according to the embodiment of the disclosed technology.
FIG. 22 is a schematic cross-sectional view illustrating an example of a configuration of a quantum operation device according to an embodiment of the disclosed technology.

### DESCRIPTION OF EMBODIMENTS

Hereinafter, an example of embodiments of the disclosed technology will be described with reference to the drawings. Note that, in each drawing, the same or equivalent components and portions are denoted with the same reference signs, and redundant description will be omitted.

### [First Embodiment]

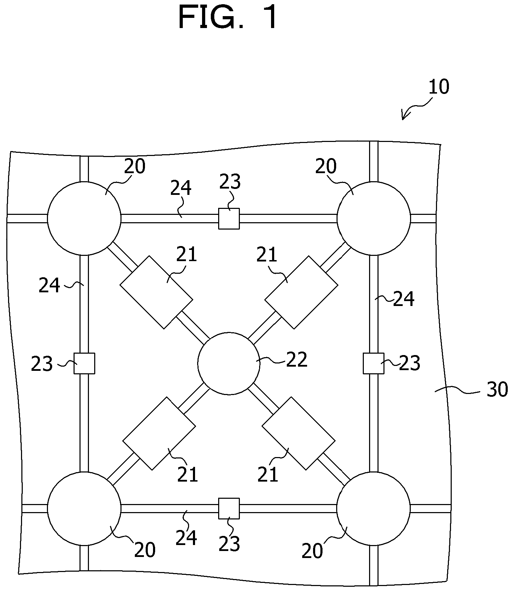

FIG. 1 is a plan view illustrating an example of a configuration of a quantum operation device 10 according to an embodiment of the disclosed technology. The quantum operation device 10 includes a qubit element (qubit) 20, a resonator 21, and a readout electrode 22 provided to a first substrate 30.

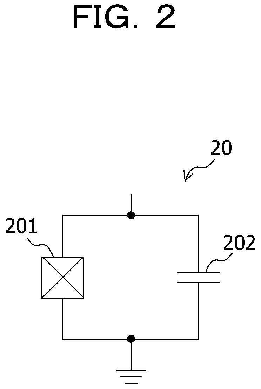

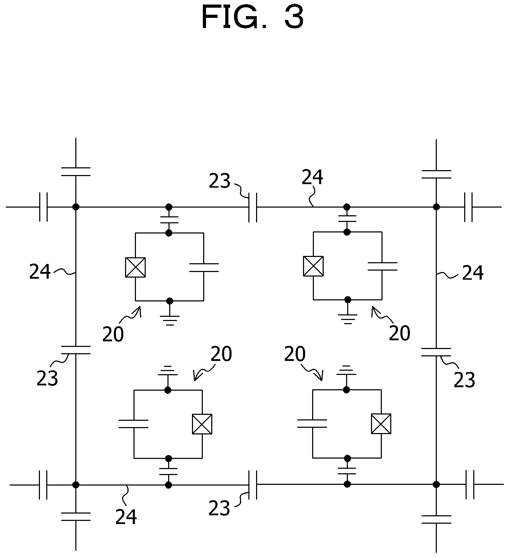

The qubit element 20 is an element that forms a coherent two-level system using superconductivity. FIG. 2 is a diagram illustrating an example of a circuit configuration of the qubit element 20. The qubit element 20 performs a quantum operation using nonlinear energy, and is configured by including a transmon qubit circuit in which a superconducting Josephson device 201 and a capacitor 202 are coupled in parallel. The superconducting Josephson device 201 is configured by including a pair of superconductors that exhibit superconductivity at a temperature equal to or lower than a predetermined critical temperature, and an ultrathin insulator having a thickness of about several nm sandwiched between the pair of superconductors. The superconductor may be, for example, aluminum, and the insulator may be, for example, aluminum oxide. As illustrated in FIG. 3, in the quantum operation device 10, a plurality of the qubit elements 20 is coupled to other adjacent qubit elements 20 via inter-bit wiring 24. Capacitors 23 are provided in a path of the inter-bit wiring 24. As a result, each of the qubit elements 20 creates a quantum entanglement state with the other adjacent qubit elements 20 and performs a quantum operation.

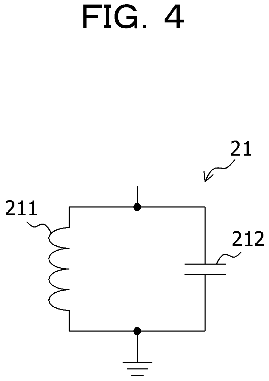

The resonator 21 interacts with the qubit element 20 to read out a bit signal indicating a state of the qubit element 20. The resonator 21 is coupled to the qubit element 20 via a capacitor (not illustrated). FIG. 4 is a diagram illustrating an example of a circuit configuration of the resonator 21. The resonator 21 is configured by including a resonance circuit in which a superconducting inductor 211 and a capacitor 212 are coupled in parallel. The readout electrode 22 is an electrode that is coupled to the resonator 21 and is for extracting the bit signal read out by the resonator 21 to the outside.

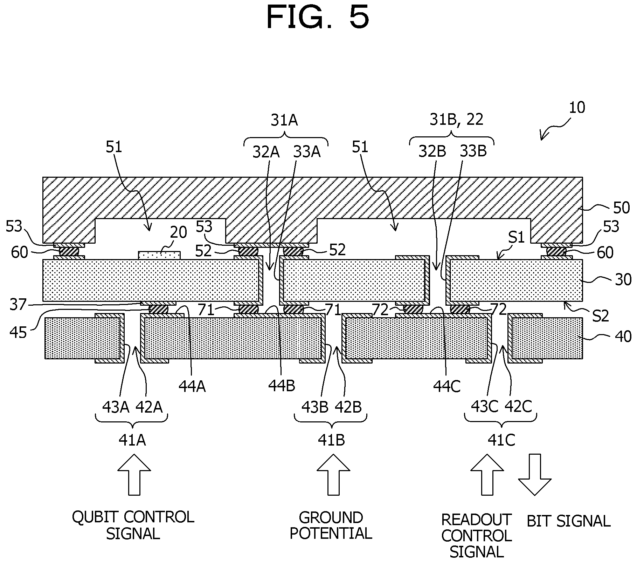

FIG. 5 is a schematic cross-sectional view illustrating an example of the configuration of the quantum operation device 10. Note that, in FIG. 5, illustration of the resonator 21 (see FIG. 1) is omitted. Furthermore, FIG. 5 illustrates only the configuration around one qubit element 20 extracted. The quantum operation device 10 has a configuration in which the first substrate 30, a second substrate 40, and a cover 50 are stacked.

The qubit element 20 is mounted to a first surface S1 of the first substrate 30. An insulating film that causes a dielectric loss is not provided to a surface of the qubit element 20. The resonator 21 not illustrated in FIG. 5 may be mounted to the first surface S1 of the first substrate 30. Through-vias 31A and 31B are provided in the first substrate 30. The through-vias 31A and 31B are configured by including through-holes 32A and 32B penetrating the first substrate 30, and conductive films 33A and 33B covering inner walls of the through-holes 32A and 32B, respectively. The conductive films 33A and 33B have portions extending at the first surface S1 and a second surface S2 opposite to the first surface S1 of the first substrate 30.

The through-via 31A is used to supply a ground potential to the first substrate 30 and the cover 50. The through-via 31B functions as the readout electrode 22. The second surface S2 of the first substrate 30 is provided with a control electrode 37 to which a qubit control signal for controlling the qubit element 20 is supplied. The control electrode 37 is arranged immediately below the qubit element 20 mounted to the first surface S1, and the qubit control signal supplied to the control electrode 37 is transmitted to the qubit element 20 via a base material of the first substrate 30.

As the base material of the first substrate 30, an insulator or a semiconductor may be used, and for example, silicon may be suitably used. The conductive films 33A and 33B constituting the through-vias 31A and 31B and the control electrode 37 are preferably configured by a metal that exhibits superconductivity at a temperature equal to or lower than a predetermined temperature. As such a metal, for example, niobium (Nb) may be suitably used.

The cover 50 covers a side of the first surface S1 of the first substrate 30. The cover 50 forms a sealed space 51 around the qubit element 20 and the readout electrode 22. Recessed portions for forming the sealed space 51 may be formed in a portion of the cover 50 facing the qubit element 20 and the readout electrode 22. The sealed space 51 communicates with the through-holes 32A and 32B. The sealed space 51 is preferably a vacuum. By making the sealed space 51 a vacuum, adsorption of a substance to the qubit element 20 may be suppressed without forming a protective film that causes a dielectric loss at the surface of the qubit element 20, and a clean state of the surface of the qubit element 20 may be always kept. Note that the vacuum is not limited to a complete vacuum, and includes a low pressure state to such an extent that an effect of substantially suppressing adsorption of a substance to the qubit element 20 is exhibited.

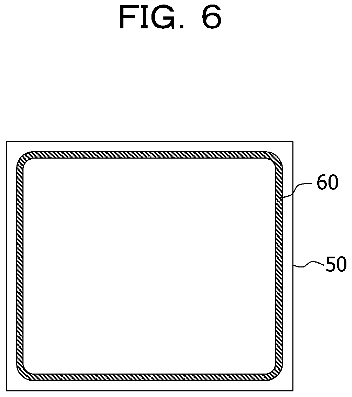

FIG. 6 is a plan view illustrating an example of a form of a seal member 60 that forms a joint portion between the cover 50 and the first substrate 30. The cover 50 is joined to the first substrate 30 via the ring-shaped seal member 60 surrounding an outer periphery of the qubit element 20 and the readout electrode 22. The cover 50 is joined to the first substrate 30 via the ring-shaped seal member 60, so that a sealed state in the sealed space 51 is achieved.

The cover 50 is preferably configured by a conductor, and is preferably configured by a metal that exhibits superconductivity at a temperature equal to or lower than a predetermined temperature. As a material constituting the cover 50, for example, aluminum (Al) may be suitably used. The cover 50 is joined to the through-via 31A to which the ground potential is supplied via a bump 52. As a result, a potential of the cover 50 may be fixed to the ground potential, and noise coming from the outside and noise radiated from the qubit element 20 and the like may be shielded. The seal member 60 and the bump 52 are preferably configured by including a metal that exhibits superconductivity at a temperature equal to or lower than a predetermined temperature. As such a metal, for example, indium (In) may be suitably used. The seal member 60 and the bump 52 are joined to the cover 50 via a conductive film 53 configured by including a metal that exhibits superconductivity at a temperature equal to or lower than a predetermined temperature, such as niobium (Nb). Note that, as the material of the cover 50, it is also possible to use an insulator or a semiconductor having a surface provided with a metal film that exhibits superconductivity.

The second substrate 40 is provided on a side of the second surface S2 of the first substrate 30. The second substrate 40 includes through-vias 41A, 41B, and 41C and conductive pads 44A, 44B, and 44C coupled to these through-vias. The through-vias 41A, 41B, and 41C are configured by including through-holes 42A, 42B, and 42C penetrating the second substrate 40, and conductive films 43A, 43B, and 43C covering inner walls of these through-holes, respectively.

The conductive pad 44A is coupled to the control electrode 37 via a bump 45. The qubit control signal is input from a back surface of the second substrate 40 (a surface opposite to a joint surface with the first substrate 30), and is supplied to the control electrode 37 via the through-via 41A, the conductive pad 44A, and the bump 45.

The conductive pad 44B is coupled to the through-via 31A of the first substrate 30 via a seal member 71. The ground potential is input from the back surface of the second substrate 40, and is supplied to various elements formed in the first substrate 30 and the cover 50 via the through-via 41B, the conductive pad 44B, the seal member 71, and the through-via 31A.

The conductive pad 44C is coupled to the through-via 31B (readout electrode 22) of the first substrate 30 via a seal member 72. A readout control signal for reading out the bit signal indicating the state of the qubit element 20 is input from the back surface of the second substrate 40 and supplied to the through-via 31B (readout electrode 22) via the through-via 41C, the conductive pad 44C, and the seal member 72. The bit signal read out from the qubit element 20 is extracted to the outside along a path opposite to the path of the readout control signal. The second substrate 40 is joined to the first substrate 30 via the bump 45 and the seal members 71 and 72.

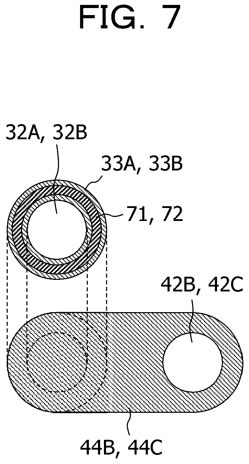

FIG. 7 is a plan view illustrating an example of forms of the seal members 71 and 72 and the conductive pads 44B and 44C. The seal members 71 and 72 respectively have a ring shape surrounding outer peripheries of open ends on the side of the second surface S2 of the through-holes 32A and 32B constituting the through-vias 31A and 31B of the first substrate 30. The through-vias 31A and 31B are respectively joined to the conductive pads 44B and 44C via the seal members 71 and 72, so that the open ends of the through-holes 32A and 32B at the second surfaces S2 are closed. As a result, the sealed space 51 communicating with the through-holes 32A and 32B is brought into a completely sealed state. In other words, the vacuum state is maintained in the sealed space 51.

As a base material of the second substrate 40, an insulator or a semiconductor may be used, and for example, silicon may be suitably used. Each of the seal members 71 and 72, the bump 45, the conductive films 43A, 43B, and 43C, and the conductive pads 44A, 44B, and 44C is preferably configured by including a metal that exhibits superconductivity at a temperature equal to or lower than a predetermined temperature. As a metal constituting the seal members 71 and 72 and the bump 45, for example, indium (In) may be suitably used. As a metal constituting the conductive films 43A, 43B, and 43C and the conductive pads 44A, 44B, and 44C, for example, niobium (Nb) may be suitably used.

A material of the second substrate 40 may be an insulator and a semiconductor. As the material of the second substrate 40, for example, silicon may be suitably used. The seal members 71 and 72 and the bump 45 are preferably configured by a metal that exhibits superconductivity at a temperature equal to or lower than a predetermined temperature. As such a metal, for example, indium (In) may be suitably used. The conductive films 43A, 43B, and 43C and the conductive pads 44A, 44B, and 44C constituting the through-vias 41A, 41B, and 41C are preferably configured by a metal that exhibits superconductivity at a temperature equal to or lower than a predetermined temperature. As such a metal, for example, niobium (Nb) may be suitably used.

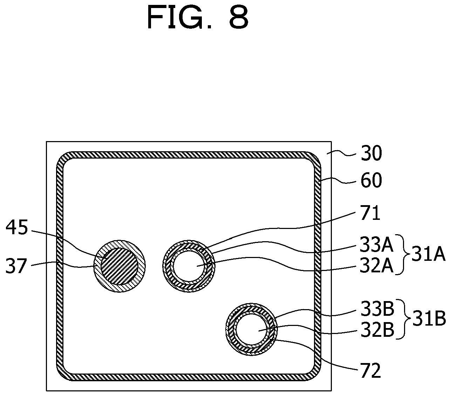

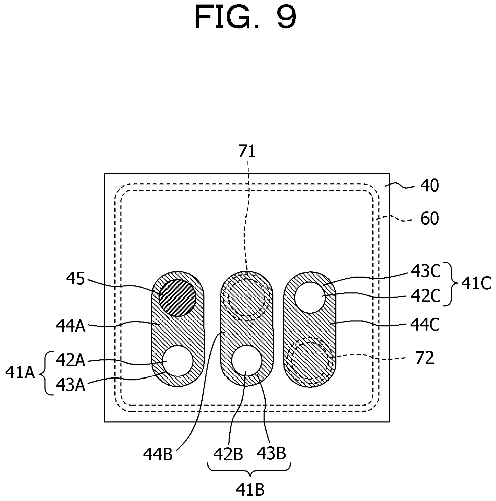

FIG. 8 is a plan view illustrating an example of arrangement of the seal member 60, the through-vias 31A and 31B, the seal members 71 and 72 associated with the through-vias 31A and 31B, the control electrode 37, and the bump 45 associated with the control electrode 37 in the first substrate 30. FIG. 9 is a plan view illustrating an example of arrangement of the through-vias 41A, 41B, and 41C, the conductive pads 44A, 44B, and 44C, and the bump 45 in the second substrate 40.

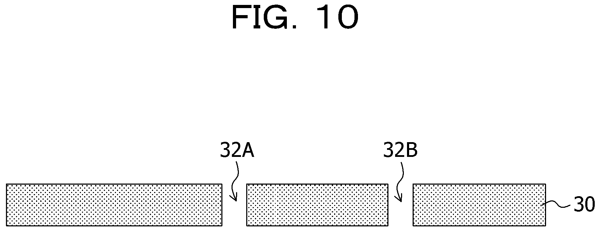

Hereinafter, an example of a method of manufacturing the quantum operation device 10 will be described with reference to FIGs. 10 to 16. First, the first substrate 30 is prepared. As the first substrate 30, for example, a silicon substrate may be used. Next, a resist (not illustrated) is formed at a surface of the first substrate 30, and this resist is patterned. Using the patterned resist as a mask, the through-holes 32A and 32B are formed in the first substrate 30 by, for example, deep reactive ion etching (RIE) (FIG. 10).

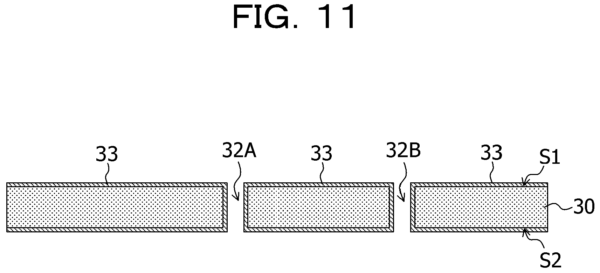

Next, a conductive film 33 including a metal that exhibits superconductivity at a temperature equal to or lower than a predetermined critical temperature, such as niobium (Nb), is formed at the first surface S1 and the second surface S2 of the first substrate 30 by a sputtering method. The inner walls of the through-holes 32A and 32B are also covered with the conductive film 33 (FIG. 11).

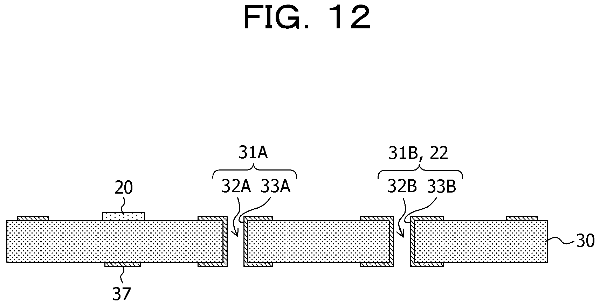

Next, the conductive film 33 is patterned by photolithography and dry etching. As a result, the through-vias 31A and 31B and the control electrode 37 are formed. The through-via 31B functions as the readout electrode 22. Furthermore, the qubit element 20 including a superconducting Josephson device is formed at the first surface S1 of the first substrate 30 using Al or the like (FIG. 12).

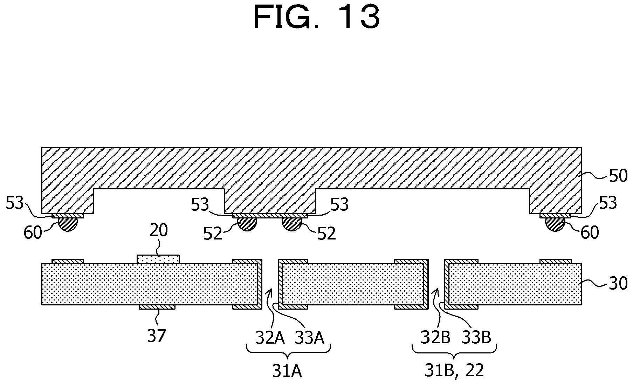

Next, the cover 50 is prepared. The cover 50 is preferably configured by, for example, a metal that exhibits superconductivity at a temperature equal to or lower than a predetermined critical temperature, such as aluminum (Al). The recessed portions may be formed in the portion of the cover 50 facing the qubit element 20 and the readout electrode 22. The ring-shaped seal member 60 is formed at the portion of the cover 50 surrounding the outer periphery of the qubit element 20 and the readout electrode 22 via the conductive film 53. Furthermore, the bump 52 is formed at a portion of the cover 50 corresponding to the through-via 31A via the conductive film 53. The seal member 60 and the bump 52 are preferably configured by a metal that exhibits superconductivity at a temperature equal to or lower than a predetermined critical temperature, such as indium (In). The conductive film 53 is preferably configured by a metal that exhibits superconductivity at a temperature equal to or lower than a predetermined critical temperature, such as niobium (Nb) (FIG. 13).

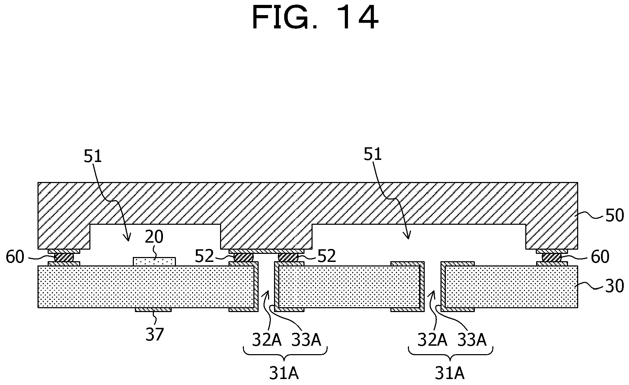

Next, the cover 50 and the first substrate 30 are housed in a vacuum chamber (not illustrated). Thereafter, oxide at surfaces of the seal member 60 and the bump 52 is removed by a surface treatment such as Ar ion milling in the vacuum chamber. Next, the first substrate 30 and the cover 50 are heated in a state of being brought into close contact with each other in the vacuum chamber. A heating temperature is determined according to melting points of the seal member 60 and the bump 52. In a case where the seal member 60 and the bump 52 are configured by indium (In), for example, the heating temperature is preferably equal to or higher than 100°C and equal to or lower than 150°C. As a result, the seal member 60 and the bump 52 are melted, the first substrate 30 and the cover 50 are joined, and the sealed space 51 communicating with the through-holes 32A and 32B is formed around the qubit element 20 and the readout electrode 22. The cover 50 is joined to the first substrate 30 via the ring-shaped seal member 60, so that the sealed state in the sealed space 51 is achieved (FIG. 14).

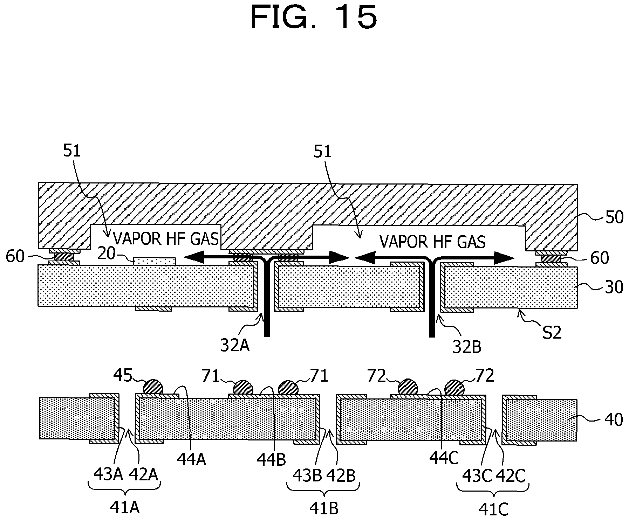

Next, the second substrate 40 is prepared. As the second substrate 40, for example, a silicon substrate may be used. Next, the through-vias 41A, 41B, and 41C and the conductive pads 44A, 44B, and 44C are formed in the second substrate 40. Formation procedures of these are similar to the formation procedures of the through-vias 31A and 31B in the first substrate 30. Next, the bump 45 is formed at a surface of the conductive pad 44A. Moreover, the seal members 71 and 72 are formed at surfaces of the conductive pads 44B and 44C. The seal members 71 and 72 respectively have the ring shape surrounding the outer peripheries of the open ends on the side of the second surface S2 of the through-holes 32A and 32B. The seal members 71 and 72 and the bump 45 are preferably configured by a metal that exhibits superconductivity at a temperature equal to or lower than a predetermined critical temperature, such as indium (In) (FIG. 15).

Next, the stack of the cover 50 and the first substrate 30, and the second substrate 40 are housed in the vacuum chamber. Thereafter, oxide at surfaces of the seal members 71 and 72 and the bump 45 is removed by the surface treatment such as the Ar ion milling. Next, a surface treatment gas such as a vapor HF gas is introduced into the sealed space 51 from the through-holes 32A and 32B in the vacuum chamber to remove oxide or the like at the surface of the qubit element 20. As a result, the surface of the qubit element 20 is cleaned without damaging the qubit element 20.

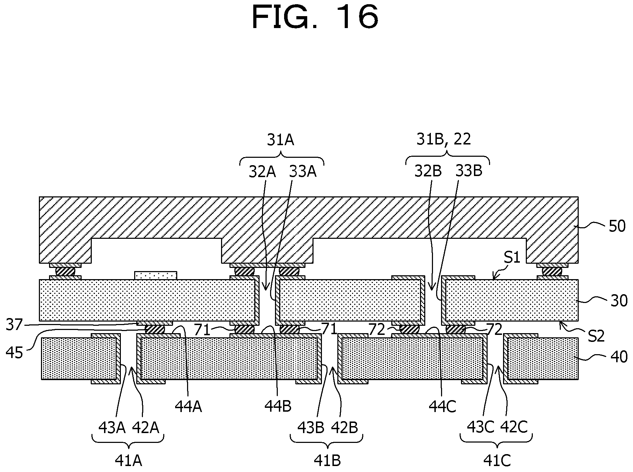

Next, the first substrate 30 and the second substrate 40 are heated in a state of being brought into close contact with each other in the vacuum chamber. A heating temperature is determined according to melting points of the seal members 71 and 72 and the bump 45. In a case where the seal members 71 and 72 and the bump 45 are configured by indium (In), for example, the heating temperature is preferably equal to or higher than 100°C and equal to or lower than 150°C. As a result, the seal members 71 and 72 and the bump 45 are melted, and the first substrate 30 and the second substrate 40 are joined. The through-vias 31A and 31B are respectively joined to the conductive pads 44B and 44C via the seal members 71 and 72, so that the open ends of the through-holes 32A and 32B at the second surfaces S2 are closed. As a result, the sealed space 51 communicating with the through-holes 32A and 32B is brought into the completely sealed state. In other words, the vacuum state is maintained in the sealed space 51 (FIG. 16).

As described above, the quantum operation device 10 includes the first substrate 30 having the first surface S1 mounted with the qubit element 20, the cover 50 covering the side of the first surface S1 of the first substrate 30, and the second substrate 40 provided on the side of the second surface S2 of the first substrate 30. The first substrate 30 includes the through-vias 31A and 31B including the through-holes 32A and 32B and the conductive films 33A and 33B. The cover 50 forms the sealed space 51 communicating with the through-holes 32A and 32B around the qubit element 20. The open ends of the through-holes 32A and 32B at the second surface S2 are closed by the second substrate 40. According to the quantum operation device 10 according to the disclosed technology, since the sealed state of the sealed space 51 is kept, the surface of the qubit element 20 may be kept clean. In other words, adsorption of a substance to the surface of the qubit element 20 may be suppressed, and shortening of a coherence time caused by the adsorbate may be avoided.

Furthermore, the second substrate 40 is joined to the first substrate 30 via the ring-shaped seal members 71 and 72 surrounding the outer peripheries of the open ends of the through-holes 32A and 32B, and the cover 50 is joined to the first substrate 30 via the ring-shaped seal member 60 surrounding the sealed space 51. As a result, the sealed space 51 may be brought into the completely sealed state and may be maintained in the vacuum state. As a result, it is possible to almost completely prevent adsorption of a substance to the surface of the qubit element 20.

The second substrate 40 includes the conductive pads 44A, 44B, and 44C electrically coupled to the through-vias 31A and 31B provided in the first substrate 30, and the through-vias 41A, 41B, and 41C electrically coupled to these conductive pads. By using the second substrate 40 as a rewiring layer in this manner, the wiring and the qubit elements 20 may be integrated at a high density, which may contribute to miniaturization of the quantum operation device 10.

Note that, in the embodiment described above, aluminum (Al), niobium (Nb), and indium (In) are exemplified as the metal that exhibits superconductivity at a temperature equal to or lower than a predetermined critical temperature, but it is also possible to use a metal such as niobium nitride (NbN), tantalum (Ta), tantalum nitride (TaN), or titanium nitride (TiN).

### [Second Embodiment]

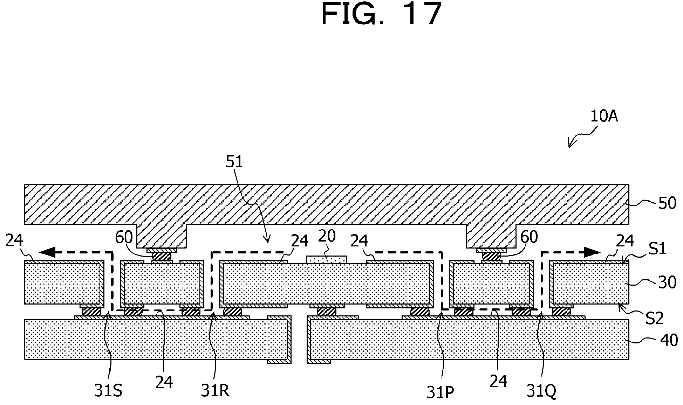

FIG. 17 is a schematic cross-sectional view illustrating an example of a configuration of a quantum operation device 10A according to a second embodiment of the disclosed technology. Note that, in FIG. 17, illustration of a resonator 21 and a readout electrode 22 is omitted. Furthermore, FIG. 17 illustrates only a configuration around one qubit element 20 extracted.

Similarly to the quantum operation device 10 according to the first embodiment, the quantum operation device 10A has a configuration in which a first substrate 30, a second substrate 40, and a cover 50 are stacked. The cover 50 covers a side of a first surface S1 of the first substrate 30 while forming a sealed space 51 around the qubit element 20. The second substrate 40 is provided on a side of a second surface S2 of the first substrate 30, and closes open ends on the side of the second surface S2 of the respective through-holes constituting through-vias 31P, 31Q, 31R, and 31S provided in the first substrate 30. Although not illustrated in FIG. 17, the first surface S1 of the first substrate 30 is mounted with a plurality of the qubit elements 20. The sealed spaces 51 are formed to be separated from each other for each qubit element 20.

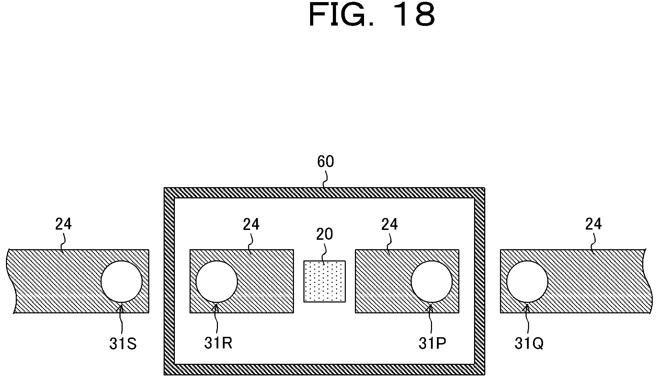

FIG. 18 is a plan view illustrating an example of a form of a seal member 60 that forms a joint portion between the cover 50 and the first substrate 30. For the respective qubit elements 20, the cover 50 is joined to the first substrate 30 via the ring-shaped seal members 60 surrounding outer peripheries of the qubit elements 20. The cover 50 is joined to the first substrate 30 via the ring-shaped seal members 60, so that sealed states in the sealed spaces 51 are achieved. The sealed spaces 51 provided for the respective qubit elements 20 are separated from each other by the seal members 60.

Each of the plurality of qubit elements 20 mounted to the first surface S1 of the first substrate 30 is coupled to other adjacent qubit elements 20 via inter-bit wiring 24. In the quantum operation device 10A according to the present embodiment, a part of the inter-bit wiring 24 is provided to the first substrate 30, and another part of the inter-bit wiring 24 is provided to the second substrate 40. In FIG. 18, portions of the inter-bit wiring 24, which are provided to the first substrate 30, are illustrated. As illustrated in FIGs. 17 and 18, portions of the inter-bit wiring 24 intersecting the seal member 60 are provided to the second substrate 40, and the other portions of the inter-bit wiring 24 are provided to the first surface S1 of the first substrate 30. In other words, the inter-bit wiring 24 bypasses to the second substrate 40 at the portions intersecting the seal member 60. The portions of the inter-bit wiring 24 provided to the first substrate 30 (hereinafter, referred to as first portions) and the portions provided to the second substrate 40 (second portions) are coupled to each other via the through-vias 31P, 31Q, 31R, and 31S.

Broken-line arrows illustrated in FIG. 17 indicate paths of bit signals from the qubit element 20 to other adjacent qubit elements (not illustrated). For example, the bit signal output from the qubit element 20 is transmitted to another adjacent qubit element (not illustrated) through the first portion of the inter-bit wiring 24, the through-via 31P, the second portion of the inter-bit wiring 24, the through-via 31Q, and the first portion of the inter-bit wiring 24.

According to the quantum operation device 10A of the present embodiment, the sealed spaces 51 are formed to be separated from each other for the respective qubit elements 20. As a result, even in a case where the vacuum state may not be maintained in one of the sealed spaces 51, the other sealed spaces 51 may be maintained in the vacuum state. In other words, as compared with a case where the plurality of qubit elements 20 is integrally vacuum-sealed, an influence in the case where the vacuum is broken may be reduced.

On the other hand, in a case where the seal members 60 surrounding the outer peripheries of the respective plurality of qubit elements 20 are provided, it is needed to arrange the inter-bit wiring 24 so as not to come into contact with the seal members 60. According to the quantum operation device 10A according to the present embodiment, since the portions of the inter-bit wiring 24 intersecting the seal members 60 bypass to the second substrate 40, contact between the inter-bit wiring 24 and the seal members 60 is avoided.

### [Third Embodiment]

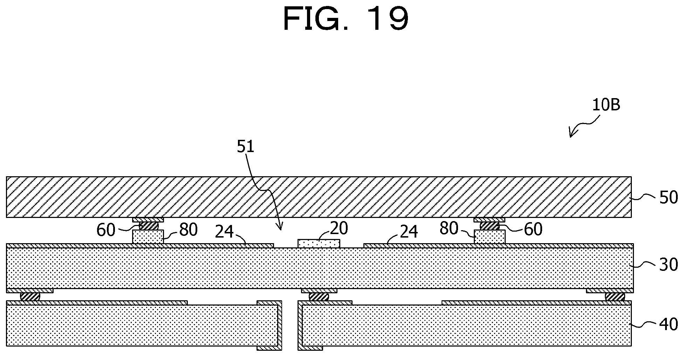

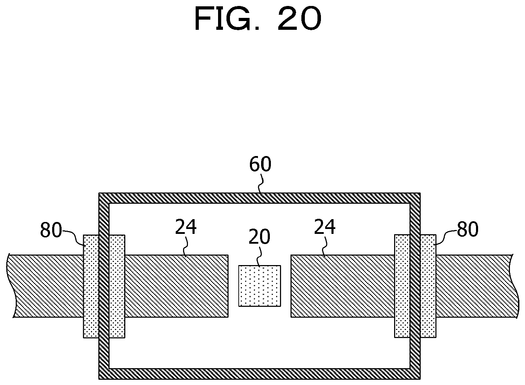

FIG. 19 is a schematic cross-sectional view illustrating an example of a configuration of a quantum operation device 10B according to a third embodiment of the disclosed technology. Note that, in FIG. 19, illustration of a resonator 21 and a readout electrode 22 is omitted. Furthermore, FIG. 19 illustrates only a configuration around one qubit element 20 extracted. FIG. 20 is a plan view illustrating an example of a form of a seal member 60 that forms a joint portion between a cover 50 and a first substrate 30. The quantum operation device 10B according to the present embodiment is different from the quantum operation device 10A according to the second embodiment described above in that all portions of inter-bit wiring 24 are provided to the first substrate 30. In the quantum operation device 10B according to the present embodiment, insulators 80 that separate the seal member 60 and the inter-bit wiring 24 are provided at intersection portions between the seal member 60 and the inter-bit wiring 24. In other words, by sandwiching the insulators 80 between the seal member 60 and the inter-bit wiring 24, contact between the seal member 60 and the inter-bit wiring 24 is avoided. According to the quantum operation device 10B according to the present embodiment, through-vias for causing the inter-bit wiring 24 to bypass to the second substrate 40 become unnecessary.

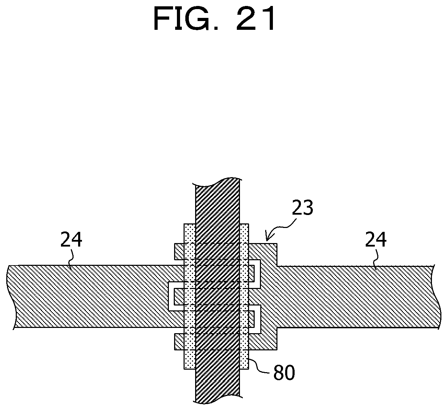

FIG. 21 is a plan view illustrating an example of a pattern of a capacitor 23 provided in a path of the inter-bit wiring 24. As exemplified in FIG. 21, the capacitor 23 may have a comb-shaped pattern. The insulator 80 provided at the intersection portion between the seal member 60 and the inter-bit wiring 24 may be provided at a position overlapping the capacitor 23. As a result, parasitic capacitance by the insulator 80 may be taken into the capacitor 23, and designing may be facilitated. Note that a configuration may be adopted in which the capacitor 23 is arranged outside a region surrounded by the seal member 60 so that one capacitor 23 is provided for two qubit elements 20 adjacent to each other.

### [Fourth Embodiment]

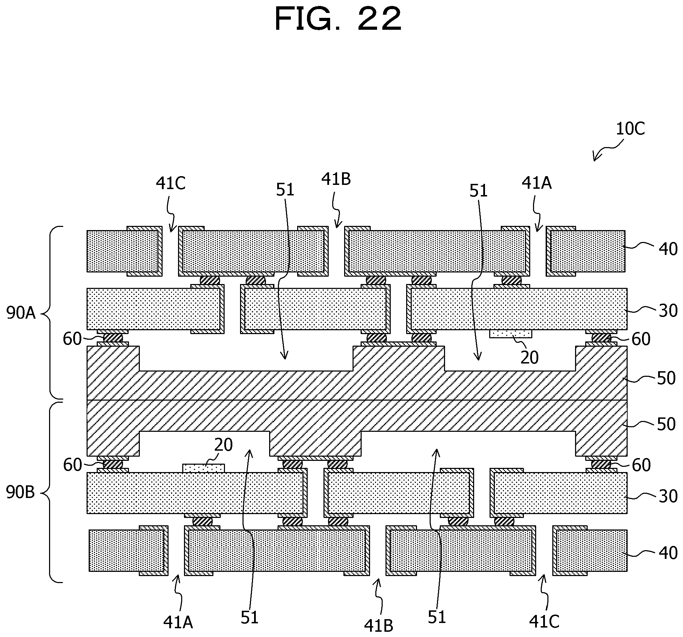

FIG. 22 is a schematic cross-sectional view illustrating an example of a configuration of a quantum operation device 10C according to a fourth embodiment of the disclosed technology. The quantum operation device 10C according to the fourth embodiment has a configuration in which structures 90A and 90B each including a cover 50, a first substrate 30, and a second substrate 40 are stacked. The structures 90A and 90B each have a configuration similar to that of the quantum operation device 10 according to the first embodiment described above. The structures 90A and 90B are stacked by joining the respective covers 50 to each other. The respective second substrates 40 are arranged in an uppermost layer and a lowermost layer of the quantum operation device 10C.

According to the quantum operation device 10C according to the present embodiment, qubit elements 20 may be integrated at a high density. Furthermore, since the second substrates 40 are arranged in the uppermost layer and the lowermost layer, wiring for accessing the qubit elements 20 may be extracted in two directions, and access to the qubit elements 20 from the two directions may be performed.

### CITATION LIST

### PATENT DOCUMENT

Patent Document 1: Japanese National Publication of International Patent Application No. 2019-532520
Patent Document 2: Japanese National Publication of International Patent Application

### REFERENCE SIGNS LIST

10, 10A, 10B, 10C Quantum operation device
20 Qubit element
23 Capacitor
24 Inter-bit wiring
30 First substrate
31A, 31B, 31C, 31P, 31Q, 31R Through-via
32A, 32BThrough-hole
33A, 33BConductive film
41A, 41B, 41C Through-via
44A, 44B, 44C Conductive pad
50 Cover
60, 71, 72 Seal member
80 Insulator
90A, 90BStructure

## Claims

1. A quantum operation device (10, 10A, 10B, 10C) comprising:
a first substrate (30) that has a through-hole (32A, 32B);
a qubit element (20) formed at a first surface (S1) of the substrate;
a cover (50) that covers a side of the first surface of the first substrate; and
a second substrate (40) that is provided on a side of a second surface (S2) opposite to the side of the first surface of the first substrate and that closes an open end of the through-hole on the side of the second surface, wherein
a sealed space (51) that surrounds the qubit element and communicates with the through-hole is provided between the first surface and the cover.

2. The quantum operation device according to claim 1, wherein
the second substrate is joined to the second surface of the first substrate via a ring-shaped seal member (71, 72) that surrounds an outer periphery of the open end.

3. The quantum operation device according to claim 1 or 2, wherein
the cover is joined to the first surface of the first substrate via a ring-shaped seal member (60) that surrounds the sealed space.

4. The quantum operation device according to any one of claims 1 to 3, wherein
the sealed space is a vacuum.

5. The quantum operation device according to any one of claims 1 to 4, wherein
the first substrate includes a through-via (31A, 31B) that includes the through-hole and a conductive film (33A, 33B) that covers an inner wall of the through-hole, and
the second substrate includes a conductive pad (44B, 44C) electrically coupled to the through-via and a through-via (41B, 41C) electrically coupled to the conductive pad.

6. The quantum operation device (10A) according to any one of claims 1 to 5, wherein
a plurality of the qubit elements is formed at the first surface of the first substrate, and
the sealed spaces are formed to be separated from each other for the respective plurality of qubit elements.

7. The quantum operation device (10A) according to claim 6, wherein at least a part of inter-bit wiring (24) that couples a pair of adjacent qubit elements to each other is provided to the second substrate.

8. The quantum operation device (10A) according to claim 7, wherein
the cover is joined to the first surface of the first substrate via a ring-shaped seal member (60) that surrounds each of the sealed spaces, and
a portion of the inter-bit wiring that intersects the ring-shaped seal member that surrounds each of the sealed spaces is provided to the second substrate.

9. The quantum operation device (10B) according to claim 6, wherein inter-bit wiring (24)
that couples a pair of adjacent qubit elements to each other is provided to the first surface of the first substrate,
the cover is joined to the first surface of the first substrate via a ring-shaped seal member (60) that surrounds each of the sealed spaces, and
an insulator (80) that separates the seal member and the inter-bit wiring is provided at an intersection portion between the seal member and the inter-bit wiring.

10. The quantum operation device (10B) according to claim 9, further comprising
a capacitor (23) provided in a path of the inter-bit wiring, wherein
the intersection portion and the insulator are provided at positions that overlap with the capacitor.

11. The quantum operation device (10C) according to any one of claims 1 to 10, wherein
a plurality of structures (90A, 90B)
each of which includes the cover, the first substrate, and the second substrate is stacked.

12. The quantum operation device according to claim 2, wherein
the ring-shaped seal member that surrounds the outer periphery of the open end is configured by including a metal that exhibits superconductivity.

13. The quantum operation device according to claim 5, wherein
the conductive film and the conductive pad are configured by including a metal that exhibits superconductivity.

14. A method of manufacturing a quantum operation device, comprising:
forming a through-hole in a first substrate;
forming a qubit element at a first surface of the first substrate;
joining a cover that covers a side of the first surface of the first substrate to the first surface of the first substrate; and
joining, to a second surface opposite to the first surface of the first substrate, a second substrate that closes an open end of the through-hole on a side of the second surface, wherein,
in the joining of the cover to the first surface, a sealed space that surrounds the qubit element and communicates with the through-hole is formed between the first surface and the cover.

15. The method of manufacturing according to claim 14, wherein
the second substrate is joined to the second surface of the first substrate via a ring-shaped seal member that surrounds an outer periphery of the open end.

16. The method of manufacturing according to claim 14 or 15, wherein
the cover is joined to the first surface of the first substrate via a ring-shaped seal member that surrounds the sealed space.

17. The method of manufacturing according to any one of claims 14 to 16, wherein
the joining of the cover to the first substrate and the joining of the second substrate to the first substrate are performed in a vacuum.

18. The method of manufacturing according to any one of claims 14 to 17, further comprising
cleaning a surface of the qubit element by introducing a gas from the open end of the through-hole, after the joining of the cover to the first substrate and before the joining of the second substrate to the first substrate.

19. The method of manufacturing according to claim 16, further comprising
removing oxide at a surface of the ring-shaped seal member that surrounds the sealed space, before the joining of the cover to the first substrate.

20. The method of manufacturing according to claim 15, further comprising
removing oxide at a surface of the ring-shaped seal member that surrounds the outer periphery of the open end, before the joining of the second substrate to the first substrate.

## Patentansprüche

1. Vorrichtung zur Durchführung von Quantenoperationen (10, 10A, 10B, 10C), umfassend:
ein erstes Substrat (30), das ein Durchgangsloch (32A, 32B) aufweist;
ein Qubit-Bauelement (20), das an einer ersten Oberfläche (S1) des Substrats gebildet ist;
eine Abdeckung (50), die eine Seite der ersten Oberfläche des ersten Substrats abdeckt; und
ein zweites Substrat (40), das auf einer Seite einer zweiten Oberfläche (S2) gegenüber der Seite der ersten Oberfläche des ersten Substrats vorgesehen ist und das ein offenes Ende des Durchgangslochs auf der Seite der zweiten Oberfläche schließt, wobei
ein abgedichteter Raum (51), der das Qubit-Bauelement umgibt und mit dem Durchgangsloch in Verbindung steht, zwischen der ersten Oberfläche und der Abdeckung vorgesehen ist.

2. Vorrichtung zur Durchführung von Quantenoperationen nach Anspruch 1, wobei
das zweite Substrat mit der zweiten Oberfläche des ersten Substrats über ein ringförmiges Dichtungselement (71, 72) verbunden ist, das einen äußeren Umfang des offenen Endes umgibt.

3. Vorrichtung zur Durchführung von Quantenoperationen nach Anspruch 1 oder 2, wobei
die Abdeckung mit der ersten Oberfläche des ersten Substrats über ein ringförmiges Dichtungselement (60) verbunden ist, das den abgedichteten Raum umgibt.

4. Vorrichtung zur Durchführung von Quantenoperationen nach einem der Ansprüche 1 bis 3, wobei
der abgedichtete Raum ein Vakuum ist.

5. Vorrichtung zur Durchführung von Quantenoperationen nach einem der Ansprüche 1 bis 4, wobei
das erste Substrat eine Durchkontaktierung (31A, 31B) einschließt, die das Durchgangsloch und eine leitfähige Schicht (33A, 33B) einschließt, die eine Innenwand des Durchgangslochs bedeckt, und
das zweite Substrat ein leitfähiges Pad (44B, 44C) einschließt, das elektrisch mit der Durchkontaktierung gekoppelt ist, und eine Durchkontaktierung (41B, 41C), die elektrisch mit dem leitfähigen Pad gekoppelt ist.

6. Vorrichtung zur Durchführung von Quantenoperationen (10A) nach einem der Ansprüche 1 bis 5, wobei
eine Vielzahl der Qubit-Bauelemente an der ersten Oberfläche des ersten Substrats gebildet ist, und
die abgedichteten Räume für die jeweilige Vielzahl von Qubit-Bauelementen so gebildet sind, dass sie voneinander getrennt sind.

7. Vorrichtung zur Durchführung von Quantenoperationen (10A) nach Anspruch 6, wobei
mindestens ein Teil einer Zwischenbit-Verdrahtung (24), die ein Paar benachbarter Qubit-Bauelemente miteinander koppelt, auf dem zweiten Substrat vorgesehen ist.

8. Vorrichtung zur Durchführung von Quantenoperationen (10A) nach Anspruch 7, wobei
die Abdeckung mit der ersten Oberfläche des ersten Substrats über ein ringförmiges Dichtungselement (60) verbunden ist, das jeden der abgedichteten Räume umgibt, und
ein Abschnitt der Zwischenbit-Verdrahtung, der das ringförmige Dichtungselement schneidet, das jeden der abgedichteten Räume umgibt, auf dem zweiten Substrat vorgesehen ist.

9. Vorrichtung zur Durchführung von Quantenoperationen (10B) nach Anspruch 6, wobei
eine Zwischenbit-Verdrahtung (24), die ein Paar benachbarter Qubit-Bauelemente miteinander koppelt, an der ersten Oberfläche des ersten Substrats vorgesehen ist,
die Abdeckung mit der ersten Oberfläche des ersten Substrats über ein ringförmiges Dichtungselement (60) verbunden ist, das jeden der abgedichteten Räume umgibt, und
ein Isolator (80), der das Dichtungselement und die Zwischenbit-Verdrahtung voneinander trennt, an einem Schnittabschnitt zwischen dem Dichtungselement und der Zwischenbit-Verdrahtung vorgesehen ist.

10. Vorrichtung zur Durchführung von Quantenoperationen (10B) nach Anspruch 9, weiter umfassend
einen Kondensator (23), der in einem Verlauf der Zwischenbit-Verdrahtung vorgesehen ist, wobei
der Schnittabschnitt und der Isolator an Positionen vorgesehen sind, die sich mit dem Kondensator überlappen.

11. Vorrichtung zur Durchführung von Quantenoperationen (10C) nach einem der Ansprüche 1 bis 10, wobei
eine Vielzahl von Strukturen (90A, 90B), von denen jede die Abdeckung, das erste Substrat und das zweite Substrat einschließt, gestapelt ist.

12. Vorrichtung zur Durchführung von Quantenoperationen nach Anspruch 2, wobei
das ringförmige Dichtungselement, das den äußeren Umfang des offenen Endes umgibt, dadurch ausgebildet ist, dass es ein Metall einschließt, das Supraleitfähigkeit aufweist.

13. Vorrichtung zur Durchführung von Quantenoperationen nach Anspruch 5, wobei
die leitfähige Schicht und das leitfähige Pad dadurch ausgebildet sind, dass sie ein Metall einschließen, das Supraleitfähigkeit aufweist.

14. Verfahren zur Herstellung einer Vorrichtung zur Durchführung von Quantenoperationen, umfassend:
Bilden eines Durchgangslochs in einem ersten Substrat;
Bilden eines Qubit-Bauelements an einer ersten Oberfläche des ersten Substrats;
Verbinden einer Abdeckung, die eine Seite der ersten Oberfläche des ersten Substrats abdeckt, mit der ersten Oberfläche des ersten Substrats; und
Verbinden, mit einer zweiten Oberfläche des ersten Substrats gegenüber der ersten Oberfläche des ersten Substrats, eines zweiten Substrats, das ein offenes Ende des Durchgangslochs auf einer Seite der zweiten Oberfläche schließt, wobei,
beim Verbinden der Abdeckung mit der ersten Oberfläche ein abgedichteter Raum, der das Qubit-Bauelement umgibt und mit dem Durchgangsloch in Verbindung steht, zwischen der ersten Oberfläche und der Abdeckung gebildet wird.

15. Verfahren zur Herstellung nach Anspruch 14, wobei
das zweite Substrat mit der zweiten Oberfläche des ersten Substrats über ein ringförmiges Dichtungselement verbunden wird, das einen äußeren Umfang des offenen Endes umgibt.

16. Verfahren zur Herstellung nach Anspruch 14 oder 15, wobei
die Abdeckung mit der ersten Oberfläche des ersten Substrats über ein ringförmiges Dichtungselement verbunden wird, das den abgedichteten Raum umgibt.

17. Verfahren zur Herstellung nach einem der Ansprüche 14 bis 16, wobei
das Verbinden der Abdeckung mit dem ersten Substrat und das Verbinden des zweiten Substrats mit dem ersten Substrat in einem Vakuum durchgeführt werden.

18. Verfahren zur Herstellung nach einem der Ansprüche 14 bis 17, weiter umfassend
Reinigen einer Oberfläche des Qubit-Bauelements durch Einführen eines Gases von dem offenen Ende des Durchgangslochs aus, nach dem Verbinden der Abdeckung mit dem ersten Substrat und vor dem Verbinden des zweiten Substrats mit dem ersten Substrat.

19. Verfahren zur Herstellung nach Anspruch 16, weiter umfassend
Entfernen von Oxid an einer Oberfläche des ringförmigen Dichtungselements, das den abgedichteten Raum umgibt, vor dem Verbinden der Abdeckung mit dem ersten Substrat.

20. Verfahren zur Herstellung nach Anspruch 15, weiter umfassend
Entfernen von Oxid an einer Oberfläche des ringförmigen Dichtungselements, das den äußeren Umfang des offenen Endes umgibt, vor dem Verbinden des zweiten Substrats mit dem ersten Substrat.

## Revendications

1. Dispositif (10, 10A, 10B, 10C) d'opération quantique comprenant :
un premier substrat (30) qui présente un trou traversant (32A, 32B) ;
un élément (20) de bit quantique formé au niveau d'une première surface (S1) du substrat ;
un couvercle (50) qui couvre un côté de la première surface du premier substrat ; et
un deuxième substrat (40) qui est fourni sur un côté d'une deuxième surface (S2) opposé au côté de la première surface du premier substrat et qui ferme une extrémité ouverte du trou traversant sur le côté de la deuxième surface, dans lequel
un espace scellé (51) qui entoure l'élément de bit quantique et communique avec le trou traversant est fourni entre la première surface et le couvercle.

2. Dispositif d'opération quantique selon la revendication 1, dans lequel
le deuxième substrat est relié à la deuxième surface du premier substrat par l'intermédiaire d'un élément d'étanchéité (71, 72) de forme annulaire qui entoure une périphérie extérieure de l'extrémité ouverte.

3. Dispositif d'opération quantique selon la revendication 1 ou la revendication 2, dans lequel
le couvercle est relié à la première surface du premier substrat par l'intermédiaire d'un élément d'étanchéité (60) de forme annulaire qui entoure l'espace scellé.

4. Dispositif d'opération quantique selon l'une quelconque des revendications 1 à 3, dans lequel
l'espace scellé est un vide.

5. Dispositif d'opération quantique selon l'une quelconque des revendications 1 à 4, dans lequel
le premier substrat inclut un trou d'interconnexion (31A, 31B) traversant qui inclut le trou traversant et un film conducteur (33A, 33B) qui couvre une paroi intérieure du trou traversant, et
le deuxième substrat inclut une pastille conductrice (44B, 44C) couplée électriquement au trou d'interconnexion traversant et un trou d'interconnexion (41B, 41C) traversant couplé électriquement à la pastille conductrice.

6. Dispositif (10A) d'opération quantique selon l'une quelconque des revendications 1 à 5, dans lequel
une pluralité des éléments de bit quantique est formée au niveau de la première surface du premier substrat, et
les espaces scellés sont formés pour être séparés les uns des autres pour la pluralité respective d'éléments de bit quantique.

7. Dispositif (10A) d'opération quantique selon la revendication 6, dans lequel
au moins une partie d'un câblage interbinaire (24) qui couple une paire d'éléments de bit quantique adjacents l'un à l'autre est fournie jusqu'au deuxième substrat.

8. Dispositif (10A) d'opération quantique selon la revendication 7, dans lequel
le couvercle est relié à la première surface du premier substrat par l'intermédiaire d'un élément d'étanchéité (60) de forme annulaire qui entoure chacun des espaces scellés, et
une portion du câblage interbinaire qui croise l'élément d'étanchéité de forme annulaire qui entoure chacun des espaces scellés est fournie jusqu'au deuxième substrat.

9. Dispositif (10B) d'opération quantique selon la revendication 6, dans lequel
un câblage interbinaire (24) qui couple une paire d'éléments de bit quantique adjacents l'un à l'autre est fourni jusqu'à la première surface du premier substrat,
le couvercle est relié à la première surface du premier substrat par l'intermédiaire d'un élément d'étanchéité (60) de forme annulaire qui entoure chacun des espaces scellés, et
un isolant (80) qui sépare l'élément d'étanchéité et le câblage interbinaire est fourni au niveau d'une portion d'intersection entre l'élément d'étanchéité et le câblage interbinaire.

10. Dispositif (10B) d'opération quantique selon la revendication 9, comprenant en outre
un condensateur (23) fourni sur un trajet du câblage interbinaire, dans lequel
la portion d'intersection et l'isolant sont fournis au niveau de positions qui se chevauchent avec le condensateur.

11. Dispositif (10C) d'opération quantique selon l'une quelconque des revendications 1 à 10, dans lequel
une pluralité de structures (90A, 90B) dont chacune inclut le couvercle, le premier substrat, et le deuxième substrat est empilée.

12. Dispositif d'opération quantique selon la revendication 2, dans lequel
l'élément d'étanchéité de forme annulaire qui entoure la périphérie extérieure de l'extrémité ouverte est configuré par l'inclusion d'un métal qui possède une supraconductivité.

13. Dispositif d'opération quantique selon la revendication 5, dans lequel
le film conducteur et la pastille conductrice sont configurés par l'inclusion d'un métal qui possède une supraconductivité.

14. Procédé de fabrication d'un dispositif d'opération quantique, comprenant :
le formage d'un trou traversant dans un premier substrat ;
le formage d'un élément de bit quantique au niveau d'une première surface du premier substrat ;
la liaison d'un couvercle qui couvre un côté de la première surface du premier substrat jusqu'à la première surface du premier substrat ; et
la liaison, jusqu'à une deuxième surface opposée à la première surface du premier substrat, d'un deuxième substrat qui ferme une extrémité ouverte du trou traversant sur un côté de la deuxième surface, dans lequel,
dans la liaison du couvercle à la première surface, un espace scellé qui entoure l'élément de bit quantique et communique avec le trou traversant est formé entre la première surface et le couvercle.

15. Procédé de fabrication selon la revendication 14, dans lequel
le deuxième substrat est relié à la deuxième surface du premier substrat par l'intermédiaire d'un élément d'étanchéité de forme annulaire qui entoure une périphérie extérieure de l'extrémité ouverte.

16. Procédé de fabrication selon la revendication 14 ou la revendication 15, dans lequel
le couvercle est relié à la première surface du premier substrat par l'intermédiaire d'un élément d'étanchéité de forme annulaire qui entoure l'espace scellé.

17. Procédé de fabrication selon l'une quelconque des revendications 14 à 16, dans lequel
la liaison du couvercle au premier substrat et la liaison du deuxième substrat au premier substrat sont réalisées dans un vide.

18. Procédé de fabrication selon l'une quelconque des revendications 14 à 17, comprenant en outre
le nettoyage d'une surface de l'élément de bit quantique par l'introduction d'un gaz depuis l'extrémité ouverte du trou traversant, après la liaison du couvercle au premier substrat et avant la liaison du deuxième substrat au premier substrat.

19. Procédé de fabrication selon la revendication 16, comprenant en outre
l'élimination de l'oxyde au niveau d'une surface de l'élément d'étanchéité de forme annulaire qui entoure l'espace scellé, avant la liaison du couvercle au premier substrat.

20. Procédé de fabrication selon la revendication 15, comprenant en outre
l'élimination de l'oxyde au niveau d'une surface de l'élément d'étanchéité de forme annulaire qui entoure la périphérie extérieure de l'extrémité ouverte, avant la liaison du deuxième substrat au premier substrat.
